Europäisches Patentamt

European Patent Office

Office européen des brevets

(11) Publication number: **0 040 917
B1**

(12) **EUROPEAN PATENT SPECIFICATION**

(45) Date of publication of patent specification: **19.03.86**

(51) Int. Cl.⁴: **G 11 C 11/40**

(21) Application number: **81301981.7**

(22) Date of filing: **06.05.81**

(54) **A static type random access memory.**

(30) Priority: **22.05.80 JP 68270/80**

(43) Date of publication of application:
**02.12.81 Bulletin 81/48**

(45) Publication of the grant of the patent:
**19.03.86 Bulletin 86/12**

(84) Designated Contracting States:
**DE FR GB**

(56) References cited:
**none**

(73) Proprietor: **FUJITSU LIMITED
1015, Kamikodanaka Nakahara-ku
Kawasaki-shi Kanagawa 211 (JP)**

(72) Inventor: **Kurafuji, Setsuo
2-5, Edakita 2-chome
Midori-ku Yokohama-shi Kanagawa 227 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

This invention relates to a static type random access memory (RAM).

The main constituent of a memory cell of a RAM of the static type is, in general, a flip-flop. The higher memory density becomes, the smaller thw cell area becomes. Therefore, the conductance gm of a driver transistor in a memory cell is reduced and as a result bit line drive capability is reduced, inevitably making the conductance gm of a load transistor of a bit line small. However, such a RAM of the static type has a disadvantage in that when the conductance gm of the load transistor of a bit line decreases, bit line charging capability becomes insufficient and therefore the readout speed of reverse data is low in a readout cycle immediately after a write cycle.

US—A—4 123 799 discloses a static IGFET RAM in which a memory cell is connected to a pair of bit lines which are connected to a power supply line via loads constituted by respective load transistors. Precharging means are also provided which comprise further transistors connected in parallel with the load transistors. In a precharging operation following a sense operation, the further transistors are turned on to precharge the bit lines.

The precharging means further comprise a balancing transistor, connected between the bit lines, which is turned on when the further transistors are turned on. This means that the bit lines of the pair are precharged to an equal voltage level.

Turning on of the further and balancing transistors is controlled by a clock voltage so that precharging is effected after each read operation to bring one bit line down and the other bit line up to the equal voltage level.

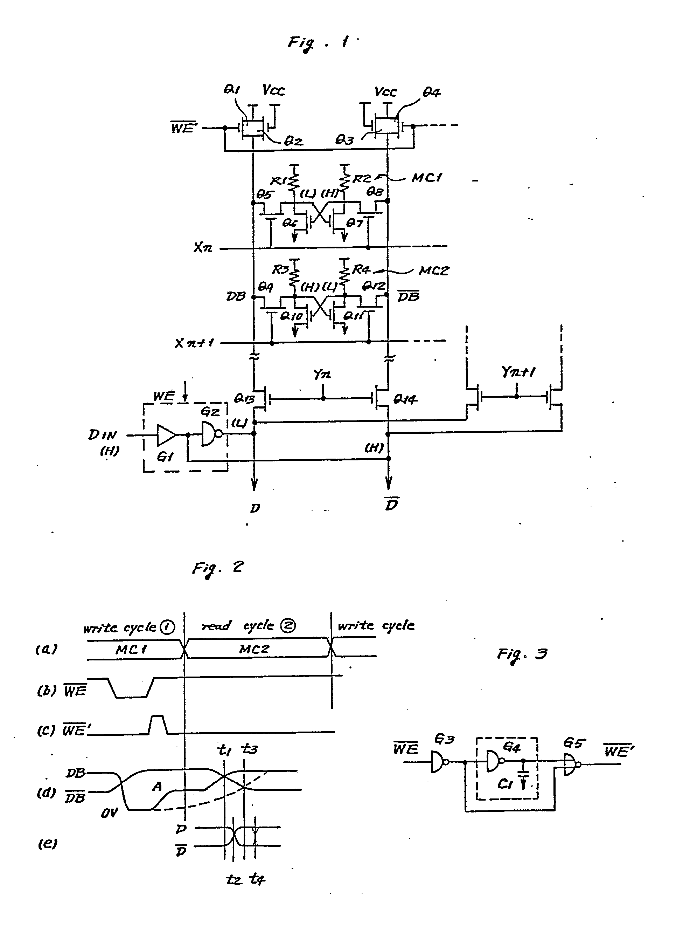

According to the present invention there is provided a static type random access memory having memory cell (MC1, MC2) which is operatively connected to a pair of bit lines (DB, $\overline{DB}$) when the memory cell is addressed, which bit lines are connected to a power supply line (Vcc) via loads (Q2, Q3) the memory being operable in a write cycle to write information into the memory cell when the memory cell is addressed and in response to a write enable signal ($\overline{WE}$) and operable in a read cycle to read information from the memory cell when the memory cell is addressed, such cycles following directly after one another, writing of information into the memory cell in a write cycle taking place when the write enable signal ($\overline{WE}$) is at a first level, the write enable signal ($\overline{WE}$) turning to a second level after information has been written into the memory cell, and the memory comprising means (Q1, Q4, Fig. 3) for temporarily reducing effective load resistance values in an end portion of a write cycle after information has been written into the memory cell (MC1, MC2), while the memory cell is still being addressed and when the write enable signal ($\overline{WE}$) has turned to the second level but before a next cycle, thereby to raise the potential of the bit line that is of lower level upon completion of writing of information into the memory cell.

The present invention can particularly provide for an improvement in relation to the disadvantages mentioned above. In an embodiment of the present invention transistors for charging bit lines are connected in parallel to loads which connect bit lines to which static type memory cells are connected, to power supply; the transistors for charging bit lines are temporarily turned ON after a write operation.

Reference is made, by way of example, to the accompanying drawings, in which:—

Figure 1 is a schematic circuit diagram illustrating circuitry of an embodiment of the present invention,

In Figure 2, (a) to (e) are waveform diagrams of operational signal waveforms, and

Figure 3 is a schematic circuit diagram of a control signal generator for bit line charge transistors of an embodiment of the present invention.

Figure 1 illustrates an embodiment of the present invention. Items illustrated in Figure 1, other then transistors $Q_1$ and $Q_4$, are similar to items conventionally used. In Figure 1, transistors $Q_1$ and $Q_4$ are used for charging bit lines and are connected in parallel with load transistors $Q_2$ and $Q_3$ of bit lines DB, $\overline{DB}$.

The bit lines DB, $\overline{DB}$ are connected with a plurality of static type memory cells, MC1, MC2 ..., which are selected by way of word lines Xn, Xn+1 ...

Yn, Yn+1, ... are bit line selection signals; for example when transistors $Q_{13}$ and $Q_{14}$ are turned ON by signal Yn, the bit lines DB, $\overline{DB}$ are selected.

Transistors $Q_5$ and $Q_8$, and transistors $Q_9$ and $Q_{12}$ of memory cells MC1 and MC2 are transfer gates, which are controlled to take ON and OFF states in dependence upon the voltage levels of the word lines Xn, Xn+1.

Each memory cell MC1, MC2 is essentially composed of a flip-flop circuit. The flip-flop circuit of MC1 is composed of load resistances $R_1$ and $R_2$, and driver transistors $Q_6$ and $Q_7$, whilst the flip-flop circuit of MC2 is composed of load resistances $R_3$ and $R_4$ and driver transistors $Q_{10}$ and $Q_{11}$.

A buffer $G_1$ and an inverter $G_2$ form a write circuit. When the buffer $G_1$ is made ready for operation by a write enable signal WE while a data input $D_{IN}$ is H (high) level, the potentials of the bit lines become DB=L, $\overline{DB}$=H. At this time, when the transfer gates $Q_5$ and $Q_8$ of the cell MC1 turn ON, the transistor $Q_6$ turns ON whilst transistor $Q_7$ turns OFF, allowing a write operation for the cell MC1.

A series of operations will be explained below with reference to Figure 2.

In Figure 2, (a) shows memory cell selection condition. Each solid line in Figure 2 (a) illustrates input signal levels corresponding to one bit of an address buffer (not illustrated) for memory cell selection addresses. In the illustrated example, an input signal which is H level (or L level) for making access to cell MC1 in a write cycle ① becomes L (or H) level for making access to cell MC2 in a read cycle ②. Moreover, write and read cycles are generated alternately.

For simplication, the explanation given hereunder will be concerned with a case in which, after a read cycle in which data is read from memory cell MC2 (with transistor $Q_{10}$ of cell MC2 OFF, and transistor $Q_{11}$ of cell MC2 ON, and with DB=H, $\overline{DB}$=L), reverse data is written into cell MC1 in write cycle ① by setting DB=L, $\overline{DB}$=H, and then reverse data is read out of cell MC2 in read cycle ② with DB=H, $\overline{DB}$=L.

Thus, the following explanation particularly relates to cycles such that the bit lines are respectively set to DB=L, $\overline{DB}$=H and reverse data is written into cell MC1, and then reverse data is read again from cell MC2 (DB=H, $\overline{DB}$=L).

At the time of data writing ①, write enable signal $\overline{WE}$ becomes L (Figure 2, (b)) making DB=L, $\overline{DB}$=H (Figure 2, (d)) by means of data input $D_{IN}$. In this case, the L level is usually reduced almost to 0V (Figure 2 (d)) in order to make the write amplitude large. Therefore, this L level is much lower than the L level (about 2.5V) at the time of readout operation. Therefore, in a conventional circuit structure, the bit line DB must be charged (from L level during data writing) by the load transistor $Q_2$ alone, from the power supply $V_{CC}$, at the time of readout ②. However, since the conductance gm of $Q_2$ is reduced as a result of advanced integration density, the potential of DB increases gradually as indicated by the broken line in Figure 2, (d). As a result, the following disadvantage is brought about: a time $t_3$ at which the potential levels of bit lines DB and $\overline{DB}$ cross, and also a time $t_4$ at which the potential levels of data outputs D and $\overline{D}$ cross each other, is delayed, reducing readout operation speed.

In order to provide an improvement in this respect, and to improve readout operation speed, in an embodiment of the present invention transistors $Q_1$ and $Q_4$, which, in an embodiment of this invention are connected in parallel with the load transistors $Q_2$ and $Q_3$, are temporarily turned ON when write operation is completed, more specifically, when write enable signal $\overline{WE}$ rises. Thereby the bit lines DB, $\overline{DB}$ are charged from the power supply $V_{CC}$ via parallel pairs of transistors $Q_1$ and $Q_2$, $Q_3$ and $Q_4$. This is equivalent to the bit line being charged by a load transistor having a large conductance gm (or equivalent to reducing the resistance value of the load on the bit line), it becomes possible quickly to raise bit line potential. These transistors $Q_1$, $Q_4$ can be controlled by a signal $\overline{WE}'$ as illustrated in Figure 2 (c) and this signal can be generated from the write enable signal $\overline{WE}$ by a circuit as shown in Figure 3.

In Figure 3, $G_3$ is an inverter and an output thereof which is an inverted version of the signal $\overline{WE}$, is guided to one input of a NOR gate· $G_5$. Simultaneously, the output of the inverter $G_3$ is also input to a delay type inverter consisting of an inverter $G_4$ and a capacitor $C_1$ and the output of the delay type inverter is led to another input of the NOR gate $G_5$. The signal $\overline{WE}'$ obtained as a result (illustrated in Figure 2(c)) is reversed in phase as compared with the signal $\overline{WE}$ and has a waveform such that H level lasts only for a certain period, determined by the capacitance of capacitor $C_1$, from the falling edge of the signal $\overline{WE}$. Thus, when the transistors $Q_1$ and $Q_4$ are turned ON by the signal $\overline{WE}'$, the bit line DB at the L level is rapidly charged after the end of writing operation and the potential increases as indicated in part A in Figure 2 (d). The increase in potential depends on the width of signal $\overline{WE}'$ and therefore that width is selected to such a degree that the bit line DB in the L level side reaches the L level at the time of readout (e.g. reaches readout L level). In other words, when a write operation is completed, the level is immediately set to the level applying for a readout time period. Thus, when the write cycle ① is completed, if the bit line DB has increased in level from the write cycle L level, the reverse data readout in thd readout cycle ② starts from such increased level, and the potential levels of the bit lines DB, $\overline{DB}$ cross at a time $t_1$ in advance of the time $t_3$, whilst the potential levels of the data outputs D, $\overline{D}$ cross at a time $t_2$, in advance of the time $t_4$. Thereby, readout operation speed of the memory cells can be improved.

As explained above, it is desirable that the period for which the transistors $Q_1$, $Q_4$ connected in parallel to the load transistors $Q_2$, $Q_3$ of the bit lines DB, $\overline{DB}$ are kept on is a selected temporary period after a time at which information is written into the memory cells.

In other words, if the transistors $Q_1$, $Q_4$ were kept ON during a read cycle, a large current would flow into the memory cells from the power supply· $V_{CC}$, causing increase of power consumption. Moreover, since the gate voltage of the transistor $Q_{10}$ in memory cell MC2, which transistor is kept OFF, would be raised by the power supply $V_{CC}$ were the transistor $Q_4$ kept ON for a long period of time, the flip-flop consisting of the transistors $Q_{10}$, $Q_{11}$ would be liable to be inverted by the influence of electronic noise and thereby information could be inverted, with a considerable degree of probability, during a read cycle of the memory cell MC2. Therefore, these possible disadvantages are eliminated in an embodiment of this invention, by turning the transistors $Q_1$, $Q_4$ ON temporarily by applying a pulse $\overline{WE}'$ to their gates after writing of information.

As explained previously the present invention offers an advantage in that a high readout operation rate can be maintained even when cell area is reduced in a RAM of the static type.

**Claims**

1. A static type random access memory having memory cell (MC1, MC2) which is operatively connected to a pair of bit lines (DB, $\overline{DB}$) when the memory cell is addressed, which bit lines are connected to a power supply line (Vcc) via loads (Q2, Q3) the memory being operable in a write cycle to write information into the memory cell when the memory cell is addressed and in response to a write enable signal ($\overline{WE}$) and operable in a read cycle to read information from the memory cell when the memory cell is addressed, such cycles following directly after one another, writing of information into the memory cell in a write cycle taking place when the write enable signal ($\overline{WE}$) is at a first level, the write enable signal ($\overline{WE}$) turning to a second level after information has been written into the memory cell, and the memory comprising means (Q1, Q4, Fig. 3) for temporarily reducing effective load resistance values in an end portion of a write cycle after information has been written into the memory cell (MC1, MC2), while the memory cell in still being addressed and when the write enable signal ($\overline{WE}$) has turned to the second level but before a next cycle, thereby to raise the potential of the bit line that is of lower level upon completion of writing of information into the memory cell.

2. A memory as claimed in claim 1, wherein the load (Q2, Q3) via which a bit line (DB, $\overline{DB}$) is connected to a power supply line (Vcc) is composed of a load transistor Q2, Q3), and the means for temporarily reducing effective load resistance value of a load comprise a further transistor (Q1, Q4) connected in parallel with the load transistor (Q2, Q3) constituting that load, and circuitry (Fig. 3) for temporarily turning the further transistor (Q1, Q4) ON so that those load and further transistors effectively provide a transistor of a larger conductance.

3. A memory as claimed in claim 2, wherein respective further transistors (Q1, Q4) are connected in parallel with respective load transistors (Q2, Q3) and jointly controlled by the said circuitry (Fig. 3).

4. A memory as claimed in claim 2 or 3, wherein the said circuitry (Fig. 3) comprises a first inverter (G3) connected to receive the write enable signal ($\overline{WE}$), a second inverter (G4, C1), being a delay inverter, connected to receive an output of the first inverter, and a NOR gate (G5) connected to receive at respective inputs thereof the output of the first inverter and an output of the delay inverter, and to provide a control signal output ($\overline{WE'}$), for controlling turning ON of the or each further transistor (Q1, Q4).

**Revendications**

1. Mémoire vive de type statique possédant une cellule de mémorisation (MC1, MC2) qui est fonctionnellement connectée à une paire de lignes de bit (DB, $\overline{DB}$) lorsque la cellule de mémorisation est adressée, lesquelles lignes de bit sont connectées à une ligne d'alimentation électrique (Vcc) via des charges (Q2, Q3), la mémoire ayant pour fonction, lors d'un cycle d'écriture, d'écrire l'information dans la cellule de mémorisation lorsque la cellule de mémorisation est adressée et en réponse à un signal de validation d'écriture ($\overline{WE}$), et ayant pour fonction, dans un cycle de lecture, de lire l'information dans la cellule de mémorisation lorsque la cellule de mémorisation est adressée, de tels cycles se suivant directment l'un l'autre, l'écriture de l'information dans la cellule de mémoire lors d'un cycle d'écriture ayant lieu lorsque le signal de validation d'écriture ($\overline{WE}$) est à un premier niveau, le signal de validation d'écriture ($\overline{WE}$) passant à un deuxième niveau après que l'information a été écrite dans la cellule de mémorisation, et la mémoire comprenant un moyen (Q1, Q4, figure 3) servant à temporairement réduire les valeurs effectives de résistance de charge dans une partie terminale d'un cycle d'écriture après que l'information a été écrite dans la cellule de mémorisation (MC1, MC2), tandis que la cellule de mémorisation est encore adressée et lorsque le signal de validation d'écriture ($\overline{WE}$) est passé au deuxième niveau, mais avant un cycle suivant, de manière à élever le potentiel de la ligne de bit qui se trouve à un niveau inférieur dès l'achèvement de l'écriture de l'information dans la cellule de mémorisation.

2. Mémoire selon la revendication 1, où la charge ($Q_2$, $Q_3$) par l'intermédiaire de laquelle une ligne de bit (DB, $\overline{DB}$) est connectée à une ligne d'alimentation électrique (Vcc) est constituée par un transistor de charge ($Q_2$, $Q_3$), et le moyen servant à temporairement réduire la valeur effective de résistance de charge d'une charge comprend un transistor supplémentaire ($Q_1$, $Q_4$) connecté en parallèle avec le transistor de charge ($Q_2$, $Q_3$) constituant cette charge, et un circuit (figure 3) servant à temporairement rendre conducteur le transistor supplémentaire ($Q_1$, $Q_4$) de façon que ce transistor de charge et ce transistor supplémentaire produisent effectivement un transistor ayant une plus grande conductance.

3. Mémoire selon la revendication 2, où les transistors supplémentaires respectifs ($Q_1$, $Q_4$) sont connectés en parallèle avec des transistors de charge respectives ($Q_2$, $Q_3$) et sont commandés conjointement par ledit circuit (figure 3).

4. Mémoire selon la revendication 2 ou 3, où ledit circuit (figure 3) comprend un premier inverseur ($G_3$) connecté de façon à recevoir le signal de validation d'écriture ($\overline{WE}$), un deuxième inverseur ($G_4$, $C_1$), qui est un inverseur à retard, connecté de façon à recevoir un signal de sortie du premier inverseur, et une porte NI ($G_5$) connectée de façon à recevoir sur ses entrées respectives le signal de sortie du premier inverseur et un signal de sortie de l'inverseur à retard, et à produire un signal de sortie de commande ($\overline{WE'}$) servant à commander la mise à l'état conducteur du transistor supplémentaire ou de chaque transistor supplémentaire ($Q_1$, $Q_4$).

**Patentansprüche**

1. Statischer Speicher mit wahlfreiem Zugriff, mit einer Speicherzelle (MC1, MC2), die wirkungsmäßig mit einem Paar von Bitleitungen (DB, DB) verbunden ist, wenn die Speicherzelle adressiert wird, wobei die Bitleitungen mit einer Stromversorgungsleitung (Vcc) über Lasten (Q2, Q3) verbunden sind und der Speicher in einem Schreibzyklus betätigbar ist, um Information in die Speicherzelle einzuschreiben, wenn die Speicherzelle adressiert wird, und in Abhängigkeit auf ein Schreibfreigabesignal (WE), und in einem Lesezyklus betätigbar ist, um Information von der Speicherzelle zu lesen, wenn diese adressiert wird, wobei solche Zyklen direkt einer nach dem anderen folgen,

wobei das Einschreiben von Information in die Speicherzelle während eines Schreibzyklus stattfindet, wenn das Schreibfreigabesignal (WE) sich auf einem ersten Pegel befindet, das Schreibfreigabesignal (WE), nachdem die Information in die Speicherzelle eingeschreiben worden ist, auf einen zweiten Pegel übergeht,

und bei welchem der Speicher Einrichtungen (Q1, Q4, Figur 3) zur temporären Reduzierung der effektiven Lastwiderstandswerte in einem Endabschnitt des Schreibzyklus umfaßt, nachdem Information in die Speicherzelle (MC1, MC2) eingeschrieben worden ist, während die Speicherzelle noch adressiert wird, und wenn das Schreibfreigabesignal (WE) auf den zweiten Pegel übergegangen ist, jedoch vor dem nächsten Zyklus, um dadurch das Potential der Bitleitung, das auf dem niedrigeren Pegel ist, bei Vollendung des Einschreibens der Information in die Speicherzelle anzuheben.

2. Speicherzelle nach Anspruch 1, bei welcher die Last (Q2, Q3), über welche eine Bitleitung (DB, DB) mit einer Stromversorgungsleitung (Vcc) verbunden ist, zusammengesetzt ist aus einem Lasttransistor (Q2, Q3),

und die Einrichtungen zur temporären Reduzierung des effektiven Lastwiderstandswertes einer Last einen weiteren Transistor (Q1, Q4) umfassen, der parallel zu dem Lasttransistor (Q2, Q3), der die Last bildet, verbunden ist,

und einen Schaltkreis (Figur 3), um temporär den weiteren Transistor (Q1, Q4) auf EIN zu schalten, so daß jene Last une weitere Transistoren effektiv einen Transistor mit einem größeren Leitwert bilden.

3. Speicher nach Anspruch 2, bei welchem weitere Transistoren (Q1, Q4) parallel mit den jeweiligen Lasttransistoren (Q2, Q3) verbunden sind und gemeinsam durch den genannten Schaltkreis (Figur 3) gesteuert werden.

4. Speicher nach Anspruch 2 oder 3, bei welchem der genannte Schaltkreis (Figur 3) einen ersten Inverter (G3) umfaßt, der angeschlossen ist, das Schreibfreigabesignal (WE) zu empfangen, und einen zweiten Inverter (G4, C1), welcher ein Verzögerungsinverter ist und zum Empfang eines Ausgangs des ersten Inverters angeschlossen ist, und ein NOR-Glied (G5), welches angeschlossen ist, um an seinen jeweiligen Eingängen den Ausgang des ersten Inverters und einen Ausgang des Verzögerungsinverters zu empfangen, und um ein Steuerausgangssignal (WE') zu liefern, um das Einschalten des oder jeden weiteren Transistors (Q1, Q4) zu steuern.

Fig . 1

Fig . 2

Fig . 3

(a) write cycle ① | read cycle ② | write cycle
MC1 | MC2

(b) $\overline{WE}$

(c) $\overline{WE'}$

(d) DB / $\overline{DB}$  A  0V

(e) D / $\overline{D}$

$t_1$ $t_3$

$t_2$ $t_4$

0 040 917

1